Europäisches Patentamt

European Patent Office

Office européen des brevets

(11) Numéro de publication: **0 028 961**
**B1**

## (12) FASCICULE DE BREVET EUROPEEN

(45) Date de publication du fascicule du brevet: **04.01.84**

(51) Int. Cl.³: **H 03 H 19/00, H 03 F 3/70**

(21) Numéro de dépôt: **80401524.6**

(22) Date de dépôt: **28.10.80**

(54) **Filtre à transfert de charges et filtre à capacités commutées comportant un multiplicateur de tension à capacités commutées.**

(30) Priorité: **09.11.79 FR 7927713**

(43) Date de publication de la demande:
**20.05.81 Bulletin 81/20**

(45) Mention de la délivrance du brevet:
**04.01.84 Bulletin 84/1**

(84) Etats contractants désignés:
**DE GB NL**

(56) Documents cités:
**FR - A - 2 437 734**

**ELECTRONICS LETTERS, vol. 15, no. 13, 21-06-1979 London GB G.C. TEMES et al.:
"Compensation for parasitic capacitances in switched capacitor filters", pages 377-379
ELECTRONIC DESIGN, vol. 27, no. 8, 12-04-1979 Rochelle Park US H. OHARA et al.: "First monolitnic PCM Filter cuts cost of Telecomm systems", pages 130-135
METHUEN'S MONDGRAPHS ON PHYSICAL SUBJECTS; High Voltage physics, L. JACOB 1934, pag. 7, 8.**

(73) Titulaire: **THOMSON-CSF
173, Boulevard Haussmann
F-75379 Paris Cedex 08 (FR)**

(72) Inventeur: **Berger, Jean-Luc
"THOMSON-CSF" SCPI 173, Bld. Haussmann
F-75360 Paris Cedex 08 (FR)**

(74) Mandataire: **Mayeux, Michèle et al,
THOMSON-CSF SCPI 173, Bld Haussmann
F-75379 Paris Cedex 08 (FR)**

Courier Press, Leamington Spa, England.

# Filtre à transfert de charges et filtre à capacités commutées comportant un multiplicateur de tension à capacités commutées

La présente invention concerne les filtres à transfert de charges et les filtres à capacités commutées comportant un multiplicateur de tension à capacités commutées.

Les filtres à capacités commutées ont été décrits, en particulier, dans deux articles de la revue américaine "Proceedings of the Institute of Electrical and Electronics Engineers": volume SC 12—N° 6—Décembre 1977—pages 592 à 608 et "International symposium on circuits and systems proceedings"—Avril 1977—pages 525 à 529.

Les filtres à capacités commutées se composent essentielement d'une cellule de filtrage et d'un amplificateur. La cellule de filtrage, qui est intégrée, a les mêmes propriétés qu'une cellule de filtrage classique, constituée de résistances et de capacités, mais elle ne comporte que des capacités et des transistors MOS. Les résistances sont remplacées par une combinaison de transistors MOS et de capacités, ce qui permet notamment de diminuer leur encombrement et d'obtenir une plus grande stabilité en température et une meilleure linéarité.

Le premier problème que notre invention cherche à résoudre est de disposer d'un amplificateur qui puisse être facilement intégre avec la cellule de filtrage.

Le même problème se pose avec les filtres à transfert de charges qui utilisent un amplificateur différentiel. De tels filtres sont connus notamment par la demande de brevet français n° 77 13 857, un nom de THOMSON-CSF, qui a été publiée sous le numéro 2.389.899.

Pour le résoudre, on remplace cet amplificateur par un multiplicateur de tension qui utilise la même technologie que la cellule de filtrage puisqu'il se compose uniquement de capacités et de transistors MOS, il peut dont être facilement intégré avec celle-ci.

On connait par l'ouvrage intitulé "High voltage physics" de L. Jacob, pages 6, 7 et 8, un multiplicateur de tension constitue par des capacités commutées périodiquement de parallele en série, et vice-versa, a l'aide de redresseurs à tubes (thermionic rectifiers).

La présente invention concerne un filtre à transfert de charges et un filtre à capacités commutées qui comportent, à la place d'un amplificateur, un multiplicateur de tension constitué de n capacités, périodiquement commutées en parallèle et une série, par des transistors du type MOS fonctionnant en commutation. Une même tension charge simultanément les n capacités commutées en parallèle et une tension amplifiée est obtenue entre les bornes extrêmes des n capacités commutées en série. De plus, les n capacités et les transistors MOS sont intégrés sur le même substrat semiconducteur.

Par la demande de brevet français n° 78.27505 déposée le 26 Septembre 1978 au nom de Thomson-CSF et par la demande de brevet européen correspondante avec désignation de l'Allemagne, de la Grande-Bretagne et des Pays-Bas, non publiées à la date de priorité de la présente demande, on connaît un tel multiplicateur.

Les capacités du multiplicateur sont réalisées dans une technologie qui comprend une couche de silice recouvrant le substrat dans laquelle sont intégrées deux couches de silicium polycristallin disposées parallèlement au substrat. Sur la couche de silice est déposée une couche d'aluminium comportant deux parties isolées l'une de l'autre et chaque armature de la capacité intégrée est constituée par une partie de la couche d'aluminium reliée à l'une des couches de silicium polycristallin.

Un deuxième problème se pose donc car chaque capacité intégrée C comporte une capacité parasite entre chacune de ses armatures et le substrat. L'une de ces capacités parasites $C_{P_2}$ est fixe et de faible valeur mais l'autre capacité parasite $C_{P_1}$ a une valeur importante et proportionnelle a la valeur de la capacité intégrée.

Les capacités parasites $C_{P_1}$ provoquent une diminution du gain de l'amplificateur à capacités commutées connue. De plus, lorsque cet amplificateur est utilisé en amplificateur différentiel, les capacités parasites $C_{P_1}$ provoquent une augmentation importante du mode commun.

On sait réaliser une compensation des capacités parasites dans le cas d'un multiplicateur différentiel comportant deux capacités à commuter. Cette compensation supprime le mode commun mais non la diminution de gain due aux capacités parasites $C_{P_1}$. Enfin, cette compensation, présente l'inconvénient majeur de n'être applicable qu'à un type d'amplificateur donne.

On sait par l'article paru dans la revue Electronics Letters du 21 Juin 1979, volume 15, n° 13, pages 377 ET 378, comment, dans un filtre à capacités commutées composé d'une cellule de filtrage et d'un amplificateur, compenser simplement et efficacement les capacités parasites $C_{P_1}$ des capacités intégrées faisant partie de la cellule de filtrage. Il faut maintenir une différence de potentiel constante sur les armatures des capacités parasites $C_{P_1}$ pour eliminer toute charge ou décharge de ces capacités en cours de fonctionnement. Pour cela, un étage suiveur de tension est connecté entre chaque borne $B_1$ de la capacité intégrée, qui est reliée a l'armature de la capacité comportant la couche inférieure de silicium polycristallin sur laquelle apparaît $C_{P_1}$, et une zone diffusée de type opposé à celui du substrat qui est disposée à l'interface silice—silicium en face des couches de silicium polycristallin.

Selon la présente invention, le multiplicateur de tension comporte un étage suiveur de tension entre la borne $B_1$ de chaque capacité intégrée et une zone diffusée dans le substrat. Seules les capacités intégrées dont la borne $B_1$ est reliée à la masse ne comportent pas d'étage suiveur et de zone diffusée.

La présente invention permet d'eliminer au premier ordre les effets parasites des capacités $C_{P1}$ de façon simple et efficace. Le gain des multiplicateurs est augmenté. Ainsi, pour un multiplicateur comportant trois capacités à commuter, on obtient maintenant un gain très proche de 3.

Le mode commun des multiplicateurs à capacités commutées différentiels est aussi pratiquement supprimé.

La présente invention présente aussi l'avantage de permettre la compensation des capacités parasites $C_{P1}$ des multiplicateurs connus, qu'ils soient différentiels ou non, et quel que soit le nombre de capacités à commuter.

D'autres objets caractéristiques et résultats de l'invention ressortiront de la description suivante, donnée a titre d'exemple non limitatif et illustrée par les figures annexées qui représentent:

— la figure 1, une vue en coupe d'une capacité intégrée avec compensation de la capacité parasite $C_{P1}$;

— la figure 2, un multiplicateur à capacités commutées;

— les figures 3, a, b et c des diagrammes de phase de signaux susceptibles d'être appliqués à un multiplicateur et à un filtre à capacités commutées selon la présente invention;

— la figure 4, un filtre à capacités commutées selon la presente invention.

Sur les différentes figures, les mêmes repères désignent les mêmes éléments, mais, pour des raisons de clarte, les cotes et proportions des différents éléments n'ont pas été respectés.

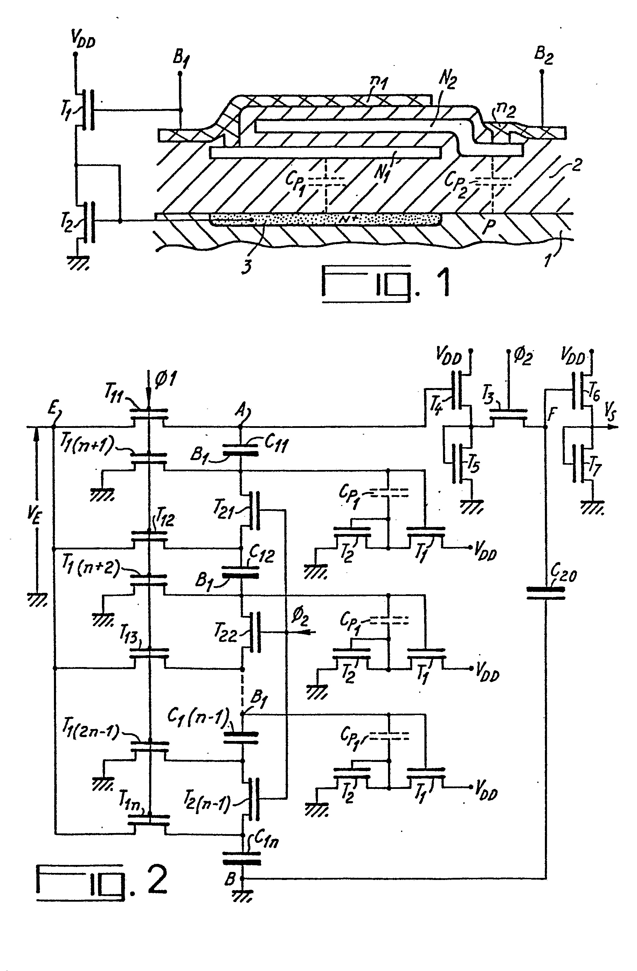

La figure 1 représente une vue en coupe d'une capacité intégrée avec compensation de la capacité parasite $C_{P1}$. Comme cela a déjà été vu précédemment, la capacité est réalisée dans une technologie qui comprend une couche de silice 2 recouvrant le substrat semi-conducteur 1 qui est généralement du silicium, de type P dans l'exemple. Deux niveaux de silicium polycristallin $N_1$ et $N_2$ sont intégrés dans la couche de silice et disposés parallèlement au substrat. Sur la couche de silice est déposée une couche d'aluminium comportant deux parties isolées l'une de l'autre par la silice n1 et n2. Chaque armature de la capacité intégrée est constituée par une partie de la couche d'aluminium reliée à l'une des couches de silicium polycristallin. On appelle $B_1$ la borne de la capacité intégrée qui est reliée a l'armature de la capacité comportant la couche inférieure $N_1$ de silicium polycristallin et $B_2$ la borne de la capacité intégrée qui est reliée à l'armature de la capacité comportant la couche supérieure $N_2$ de silicium polycristallin.

Les couches de silice séparant les différentes métallisations sont minces par rapport à la couche de silice les séparant du substrat. La présence du substrat semi-conducteur 1, portant la couche d'oxyde 2, qui est pris généralement comme référence des potentiels, introduit une capacité parasite $C_{p1}$ et $C_{p2}$ sur les bornes $B_1$ et $B_2$ de chaque capacité intégrée. Ces capacités parasites sont représentées en pointillé sur la figure 1.

Les valeurs de $C_{p1}$ et $C_{p2}$ sont différentes. La valeur de $C_{p1}$ est importante et proportionnelle à la valeur de la capacité C intégrée. La valeur de $C_{p2}$ est fixe et peut être rendue très faible en modifiant le dessin de la couche d'aluminium $n_2$. La capacité parasite $C_{p1}$ est donc particulièrement gênante. On compense cette capacité en maintenant une différence de potentiel constante sur ses armatures de façon à éliminer toute charge ou décharge de cette capacité en cours de fonctionnement. Pour cela, on réalise à l'interface silice-silicium, en face des couches de silicium polycristallin $N_1$ et $N_2$, une zone diffusée 3 de type opposé à celui du substrat. Dans l'exemple représenté sur la figure 1, la zone diffusée est de type $N^+$ car le substrat est de type P. Un étage suiveur de tension est connecté entre la borne $B_1$ et la zone diffusée 3.

Cet étage suiveur de tension est constitué de deux transistors MOS $T_1$ et $T_2$ qui sont connectés en série entre une tension de polarisation $V_{DD}$ et la masse. La borne $B_1$ de la capacité intégree est connectée à la grille du transistor $T_1$, relié à $V_{DD}$, tandis que la zone diffusée 3 et l'electrode commune à $T_1$ et $T_2$ sont connectées a la grille du transistor $T_2$ relié à la masse.

Cet étage suiveur de tension est généralement intégré dans le substrat semi-conducteur 1. Le montage représenté sur la figure 1 permet de compenser la capacité parasite $C_{P1}$; il serait également possible de compenser la capacité parasite $C_{P2}$ mais, cela n'est généralement pas intéressant à cause de sa très faible valeur.

La figure 2 représente un multiplicateur à capacités commutées selon la présente invention.

Soient $C_{11}$, $C_{12}$... $C_{1n}$, les n capacités à commuter périodiquement de parallèle en série et vice-versa.

$(n-1)$ transistor MOS $T_{21}$ à $T_{2(n-1)}$ sont connectés par leurs drains et leurs sources entre les bornes de deux capacités successives, seules les deux bornes extrêmes sont laissées libres: la borne A de la capacité $C_{11}$ et la borne B de la capacité $C_{1n}$.

n transistor MOS, $T_{11}$ à $T_{1n}$, sont connectés par leurs drains et leurs sources entre l'une des bornes de chaque capacité, parmi lesquelles la borne extrême A, et l'entrée E où est appliquée une tension $V_E$.

$(n-1)$ transistor MOS, $T_{1(n+1)}$ à $T_{1(2n-1)}$ sont connectés par leurs drains et leurs sources entre l'autre borne de chaque capacité et la masse, exceptée la borne B qui est reliée directement à la masse.

Les transistors MOS sont commandés par deux signaux périodiques $\phi_1$ et $\phi_2$ appliqués, respectivement, aux grilles des transistors $T_{11}$ à $T_{1(2n-1)}$, appartenant à un premier groupe de transistors $G_1$, et $T_{21}$ à $T_{2(n-1)}$, appartenant à un deuxième groupe de transistors $G_2$.

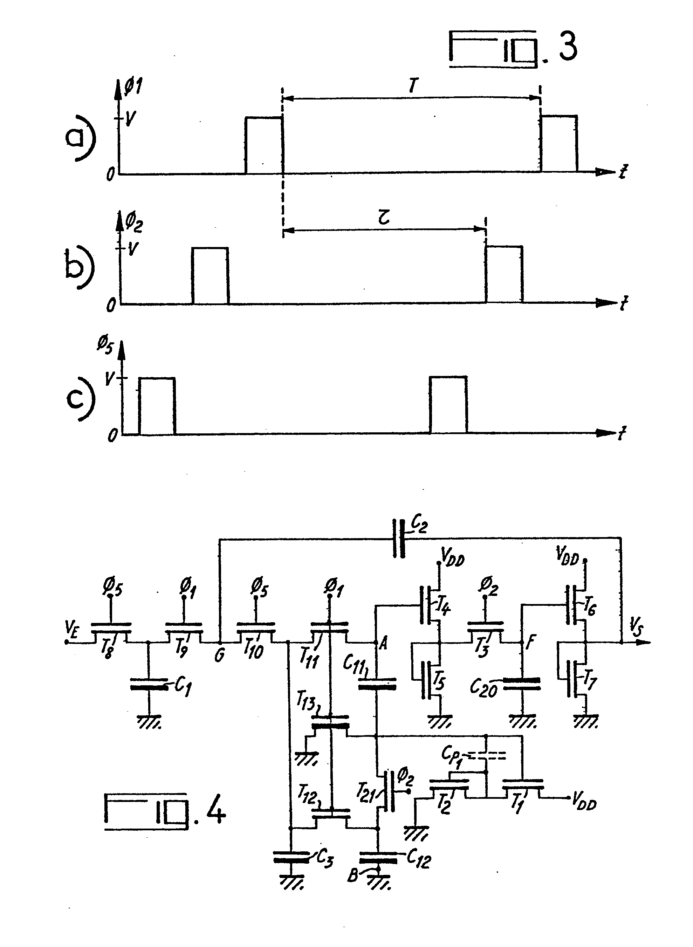

Les figures 3a et 3b représentent les diagrammes de phase des signaux périodiques $\phi_1$ et $\phi_2$.

L'amplitude des potentiels $\phi_1$ et $\phi_2$ varie, en volts, entre O et V, sensiblement en créneaux, avec une période T. Les potentiels $\phi_1$ et $\phi_2$ ne sont jamais simultanément à V et le passage de $\phi_1$ et V à zéro est séparé du passage de $\phi_2$ de zéro a V par un intervalle de temps $\tau$ non nul.

Lorsque le signal $\phi_1$ prend la valeur V, les transistors $T_{11}$ a $T_{1(2n-1)}$ du premier groupe conduisent. La tension $V_E$ charge alors les n capacités, en parallèle, à travers les transistors $T_{11}$ a $T_{1n}$, alors qu'une borne de ces capacités est maintenue à la masse grâce aux transistors $T_{1(n+1)}$ à $T_{1(2n-1)}$.

Lorsque le signal $\phi_1$ prend la valeur zéro qui bloque les transistors MOS du premier groupe, les n capacités sont alors chargées à la tension $V_E$.

Après un intervalle de temps $\tau$ non nul, pour que les transistors des deux groupes ne soient pas simultanément conducteurs, le signal $\phi_2$ passe à V et rend conducteur les transistors $T_{21}$ à $T_2(n-1)$ du deuxième groupe. Les n capacités sont alors en série et la tension entre le point A et la masse égale n. $V_E$.

Le premier groupe de transistors MOS assure donc la commutation en parallèle des n capacités et le deuxième groupe leur commutation en série.

Sur la figure 2, on a représenté en trait épais l'armature de chaque capacité intégrée C qui est reliée à la borne $B_1$ et en trait mince l'armature de chaque capacité intégrée C qui est reliée à la borne $B_2$.

Seule la capacité $C_{1n}$, dont la borne $B_1$ est reliée à la masse ne comporte pas d'étage suiveur et de zone diffusée. Toutes les autres capacités du multiplicateur $C_{11}$ à $C_1(n-1)$ comportent une zone diffusée 3 et un étage suiveur de tension entre la borne $B_1$ et la zone diffusée 3, qui est analogue à celui représenté sur la figure 1. Sur la figure 2, on a représenté les étages suiveurs aux bornes des capacités parasites $C_{p1}$ qui sont représentées symboliquement en pointillés.

L'étage de sortie du multiplicateur comporte un premier étage suiveur de tension connecté au point A. Cet étage suiveur de tension est constitué de deux transistors MOS $T_4$ et $T_5$ en série entre la tension de polarisation $V_{DD}$ et la masse. Le point A est connecté a la grille de $T_4$, relié à $V_{DD}$, tandis que la sortie de cet étage suiveur est constituée par la borne commune à $T_4$ et $T_5$ à laquelle est reliée la grille de $T_5$.

En sortie de l'étage suiveur, est connecté un transistor MOS $T_3$ recevant sur sa grille le signal $\phi_2$ et permettant le transfert de la tension amplifiée n. $V_E$ lorsque $\phi_2$ est au niveau haut.

En sortie de $T_3$ au point F est connectée une capacité de maintien $C_{20}$, également reliée au point B.

Enfin, en série avec $T_3$ est connecté un deuxième étage suiveur analogue au premier et constitué de deux transistors MOS $T_6$ et $T_7$. Cet étage fournit la tension de sortie $V_S$.

Comme les capacités $C_{11}$ à $C_{1n}$, la capacité $C_{20}$ est intégrée dans le substrat semi-conducteur. Sa borne $B_1$ est reliée au point F. Ainsi la capacité parasite $C_{p1}$ vient s'ajouter la valeur de $C_{10}$ ce qui permet d'intégrer sur le substrat semi-conducteur une capacité $C_{20}$ de plus faible valeur.

Le multiplicateur représenté sur la figure 2 peut également fonctionner en amplificateur différentiel. Il faut pour cela que les transistors MOS $T_{1(n+1)}$ à $T_{1(2n-1)}$ ne soient plus connectés à la masse mais à une deuxième entrée de l'amplificateur E'. Il faut aussi que le point B ne soit plus connecté à la masse mais à un transistor MOS $T_{1(2n)}$ relié à la deuxième entrée E' de l'amplificateur. Dans ce cas, il est nécessaire de compenser la capacité parasite $C_{p1}$ sur la borne $B_1$ de la capacité $C_{1n}$. Une diffusion 3 est donc prevue sur cette capacité et un étage suiveur est connecté entre les bornes de sa capacité parasite $C_{p1}$. Un transistor $T_{2n}$ est généralement connecte entre le point B et une tension de référence $V_R$. Ce transistor reçoit sur sa grille le signal $\phi_2$ et permet le réglage d'une éventuelle tension d'offset.

Ce multiplicateur à capacité commutée est utilisé dans des filtres à capacités commutées et dans des filtres à transfert de charges.

Sur la figure 4, un filtre à capacités commutées du type passe-bas est pris comme exemple.

La cellule de filtrage est constituée par deux résistances en série avec l'entrée du multiplicateur et par une capacité entre l'entrée du multiplicateur et la masse. D'autre part, une capacité, reliée entre la sortie du multiplicateur et le point commun aux resistances, assure le bouclage du filtre. Sur la figure 4, la première résistance est constituée par les transistors MOS $T_8$ et $T_9$ en série et par une capacité $C_1$ entre le point commun à ces transistors et la masse. La deuxième resistance est constituée par le transistor MOS $T_{10}$ qui est relié au transistor $T_9$ et par une capacité $C_3$ connectée entre l'autre borne de $T_{10}$ et la masse. Cette deuxième résistance comporte également les transistors $T_{11}$ et $T_{12}$ qui appartiennent à un multiplicateur à capacité commutée analogue à celui représenté sur la figure 2 mais qui ne comporte par exemple, que deux capacités à commuter $C_{11}$ et $C_{12}$ entre le point A et le point B. Dans l'exemple représenté sur la figure 4, la capacité de la cellule de filtrage qui est connectée entre l'entrée du multiplicateur et la masse est confondue avec les deux capacités à commuter $C_{11}$ et $C_{12}$ du multiplicateur. La capacité $C_2$ qui est connectée entre la sortie du multiplicateur et le point G commun aux transistors $T_9$ et $T_{10}$ assure le bouclage du filtre.

Les bornes $B_1$ des capacités $C_1$, $C_3$, et $C_{12}$ sont reliées à la masse et il n'est donc pas nécessaire de compenser les capacités parasites $C_{p1}$ qui apparaissent sur ces bornes. Seule la première capacité à commuter $C_{11}$ nécessite une compensation de sa capacité parasite $C_{p1}$ et comporte, comme représenté sur la figure 1, un étage suiveur de tension aux bornes de sa capacité parasite $C_{p1}$, c'est-à-dire entre sa borne $B_1$ et une zone diffusée 3.

En ce qui concerne la capacité de bouclage $C_2$, sa borne $B_1$ est reliée à la sortie du multiplicateur car cette sortie se fait à faible impédance et la capacité parasite $C_{p1}$ due à $C_2$ n'y provoque pas de pertubation. Les transistors $T_8$ et $T_{10}$ reçoivent un signal périodique $\phi_5$, le transistor $T_9$ et les transistors $T_{11}$, $T_{12}$, $T_{13}$ reçoivent le signal $\phi_1$ et les transistors $T_3$ et $T_{21}$ reçoivent le signal $\phi_2$.

Le signal $\phi_5$ est un signal analogue à $\phi_1$ et $\phi_2$, qui varie, sensiblement en créneaux, entre un niveau zero et un niveau V, avec une période T. Le signal $\phi_5$ se trouve au niveau V alors que $\phi_1$ et $\phi_2$ sont au niveau bas, le signal $\phi_5$ revient au niveau zéro avant que $\phi_2$ passe au niveau V.

La réponse en fréquence du filtre représenté sur la figure 4 est analogue à celle d'un filtre du second ordre mais comporte un pôle supplémentaire à la fréquence moitié de la fréquence d'echantillonnage ce qui n'affecte pas le comportement en basse fréquence.

Le multiplicateur selon la présente invention est également utilisé dans un filtre à transfert de charges dans sa version amplificateur différentiel. Il sert alors à réaliser la différence des tensions obtenues à partir des charges recueillies sur les electrodes coupées du filtre. Le multiplicateur différentiel selon la présente invention est bien adapté à ce genre d'application car les signaux périodiques $\phi_1$ et $\phi_2$ nécessaires à son fonctionnement peuvent être confondus avec les signaux utilisés dans le fonctionnement du dispositif à transfert de charges. De plus, ce multiplicateur traite des signaux échantillonnés et ce sont des signaux échantillonnés qui parviennent des moyens de lecture du dispositif à transfert de charges.

## Revendications

1. Filtre à transfert de charges comportant un amplificateur différentiel qui réalise la différence des tensions obtenues a partir des charges recueillies sur les électrodes coupées du filtre, caractérisé en ce que cet amplificateur est constitué par un multiplicateur de tension, comportant n capacités ($C_{11}$ à $C_{1n}$ Fig. 2), périodiquement commutées en parallèle et en série, par des transistors du type MOS ($T_{11}$ à $T_{2(n-1)}$ Fig. 2) fonctionnant en commutation, une même tension chargeant simultanément les n capacités commutées en parallèle et une tension amplifiée étant obtenue entre les bornes extrêmes (A et B Fig. 2), des n capacités commutées en série, et en ce que les n capacités et les transistors MOS sont intégrés sur le même substrat semiconducteur, et en ce que les n capacités sont réalisées sur un substrat semi-conducteur (1, Fig. 1) en silicium recouvert d'une couche de silice (2, Fig. 1) dans laquelle sont intégrées deux couches ($N_1$, $N_2$, Fig. 1) de silicium polycristallin disposées parallèlement au substrat, une couche d'aluminium comportant deux parties ($n_1$, $n_2$, Fig. 1) isolées l'une de l'autre étant déposée sur la silice, les armatures de chaque capacité intégrée étant constituées par une partie de la couche d'aluminium reliée à l'une des couches de silicium polycristallin, et en ce qu'un étage suiveur ($T_1$, $T_2$, Fig. 1) de tension est connecté entre la borne ($B_1$, Fig. 1) de chaque capacité intégrée reliée à l'armature de la capacité comportant la couche inférieure ($N_1$, Fig. 1) de silicium polycristallin et une zone diffusée (3 Fig. 1) de type opposé à celui du substrat (1, Fig. 1) qui est disposée à l'interface silice-silicium en face des couches de silicium polycristallin, seules les capacités intégrées dont la borne ($B_1$, Fig. 1) est reliée à la masse ne comportant pas d'étage suiveur et de zone diffusée.

2. Filtre à capacités commutées comportant une cellule de filtrage constituée de capacités et de transistors MOS associée à un amplificateur, caractérisé en ce que cet amplificateur est constitué par un multiplicateur de tension, comportant n capacités ($C_{11}$ à $C_{1n}$, Fig. 2), périodiquement commutées en parallèle et en série, par des transistors du type MOS ($T_{11}$ à $T_{2(n-1)}$ Fig. 2) fonctionnant en commutation, une même tension chargeant simultanément les n capacités commutées en parallèle et une tension amplifiée étant obtenue entre les bornes extrêmes (A et B Fig. 2) des n capacités commutées en série, et en ce que les n capacités et les transistors MOS constituant l'amplificateur sont intégrés sur le même substrat semi-conducteur et en ce que les n capacités constituant l'amplificateur sont réalisées sur un substrat semi-conducteur (1, Fig. 1) en silicium recouvert d'une couche de silice (2, Fig. 1) dans laquelle sont intégrées deux couches ($N_1$, $N_2$, Fig. 1) de silicium polycristallin disposées parallèlement au substrat, une couche d'aluminium ($n_1$, $n_2$, Fig. 1) comportant deux parties isolées l'une de l'autre étant déposée sur la silice, les armatures de chaque capacité intégrée constituant l'amplificateur étant constituées par une partie de la couche d'aluminium reliée à l'une des couches de silicium polycristallin, et en ce qu'un étage suiveur de tension ($T_1$, $T_2$, Fig. 1) a son entrée connecté à la borne ($B_1$, Fig. 1) de chaque capacité intégrée constituant l'amplificateur qui est reliée à l'armature de la capacité comportant la couche inférieure ($N_1$, Fig. 1) de silicium polycristallin et sa sortie à une zone diffusée (3 Fig. 1) de type opposé à celui du substrat (1 Fig. 1) qui est disposée à l'interface silice-silicium en face des couches de silicium polycristallin, seules les capacités intégrées constituant l'amplificateur dont la borne ($B_1$, Fig. 1) est reliée à la masse ne comportant pas d'étage suiveur et de zone diffusée.

3. Filtre selon l'une des revendication 1 ou 2, caractérisé en ce que l'étage suiveur de tension est constitué par deux transistors MOS ($T_1$, $T_2$) en série entre une tension de polarisation ($V_{DD}$) et la masse, la borne $B_1$ de la capacité intégrée étant connectée à la grille du transistor ($T_1$) relié à la tension de polarisation tandis que la zone diffusée (3) et l'electrode commune aux deux transistors sont connectées à la grille du transistor ($T_2$) relié à la masse.

4. Filtre selon l'une des revendications 1 ou 3, caractérisé en ce que l'étage suiveur de tension est intégré dans le même substrat semiconducteur (1) que le reste du filtre.

5. Filtre selon l'une des revendications 1 à 4, caractérisé en ce que l'étage de sortie du multiplicateur est constitué par un premier étage suiveur de tension, connecté au point A en série avec un transistor MOS $T_3$ recevant sur sa grille le signal $\phi_2$, ce transistor étant suivi par un deuxieme étage suiveur de tension tandis qu'une capacité de maintien ($C_{20}$) est connectée entre le point B et un point F commun au deuxième étage suiveur et au transistor $T_3$, la borne $B_1$ de cette capacité étant connectée au point F.

6. Filtre selon l'une des revendications 2 à 5, caractérisé en ce que le multiplicateur à commutation de capacités comporte des capacités à commuter confondues avec la derniere capacité de la cellule de filtrage, cette cellule de filtrage comportant en outre deux résistance en série constituées d'une part de deux transistors MOS ($T_8$, $T_9$) en série et d'une capacité ($C_1$) entre leur point commun et la masse, et d'autre part, d'un transistor MOS ($T_{10}$) en serie avec les transistors $T_{11}$ et $T_{12}$ de l'amplificateur et d'une capacité ($C_3$) entre leur point commun et la masse, les bornes $B_1$ des deux capacités intégrées ($C_1$, $C_3$) constituant les résistances étant reliées à la masse, la cellule de filtrage comportant également une capacité de bouclage ($C_2$) entre la sortie du multiplicateur et le point commun aux résistances, la borne $B_1$ de cette capacité intégrée étant reliée a la sortie de l'amplificateur.

## Patentansprüche

1. Ladungstransferfilter mit einem Differentialverstärker, der die Differenz der ausgehend von den Schnittelektroden des Filters erhaltenen Spannungen bildet, dadurch gekennzeichnet, daß der Verstärker aus einem Spannungsmultiplizierer besteht, der n periodisch in Parallelbetrieb und in Serienbetrieb durch als Schalter wirkende MOS-Transistoren ($T_{11}$ bis $T_{2(n-1)}$, Fig. 2) umgeschaltete Kondensatoren ($C_{11}$ bis $C_{1n}$, Fig. 2) aufweist, wobei eine Spannung gleichzeitig die n parallelgeschalteten Kondensatoren auflädt und eine verstärkte Spannung zwischen den äußersten Klemmen (A und B, Fig. 2) der seriengeschalteten Kondensatoren erhalten wird, und daß die n Kondensatoren und die MOS-Transistoren auf einem gemeinsamen Halbleitersubstrat integriert sind, und daß die n Kondensatoren auf einem halbleitenden Siliziumsubstrat (1, Fig. 1) ausgebildet sind, das mit einer Schicht aus Siliziumoxid (2, Fig. 1) bedeckt ist, wobei in diese Schicht parallel zum Substrat zwei Schichten ($N_1$, $N_2$, Fig. 1) aus polykristallinem Silizium integriert sind und eine Aluminiumschicht, die zwei gegeneinander isolierte Bereiche ($n_1$, $n_2$) enthält, auf das Siliziumoxid aufgebracht ist, daß die Platten jedes integrierten Kondensators aus einem an eine der Schichten aus polykristallinem Silizium angeschlossenen Bereich der Aluminiumschicht bestehen und daß eine Spannungsfolgerstufe ($T_1$, $T_2$, Fig. 1) zwischen die die Platte des die tiefergelegene Schicht ($N_1$, Fig. 1) aus polykristallinem Silizium betreffende Klemme ($B_1$, Fig. 1) jedes integrierten Kondensators und eine Diffusionszone (3, Fig. 1) entgegengesetzten Typs wie das Substrat (1, Fig. 1) angeschlossen ist, die an der Grenzschicht Siliziumoxid-Silizium in Höhe der Schichten aus polykristallinem Silizium angebracht ist, wobei nur die integrierten Kondensatoren, deren Klemme ($B_1$, Fig. 1) an Masse liegt, keine Folgerstufe und keine Diffusionszone aufweisen.

2. Filter mit umgeschalteten Kondensatoren und mit einer aus Kondensatoren und MOS-Transistoren gebildeten Filterzelle, die einem Verstärker zugeordnet ist, dadurch gekennzeichnet, daß dieser Verstärker aus einem Spannungsmultiplizierer besteht und n periodisch mithilfe von als Schalter wirkenden Transistoren vom MOS-Typ ($T_{11}$ bis $T_{2(n-1)}$, Fig. 2) in Parallel- und in Serienbetrieb umgeschaltete Kondensatoren ($C_{11}$ bis $C_{1n}$, Fig. 2) aufweist, wobei eine gemeinsame Spannung gleichzeitig die n parallelgeschalteten Kondensatoren auflädt und eine verstärkte Spannung zwischen den äußersten Klemmen (A und B, Fig. 2) der n in Reihe geschalteten Kondensatoren erhalten wird, und daß die n Kondensatoren und die MOS-Transistoren, die den Verstärker bilden, auf einem gemeinsamen Halbleitersubstrat integriert sind, und daß die n den Verstärker bildenden Kondensatoren auf einem Halbleitersubstrat (1, Fig. 1) aus Silizium mit einer Deckschicht aus Siliziumoxid (2, Fig. 1) hergestellt sind, in die zwei Schichten aus polykristallinem Silizium ($N_1$, $N_2$, Fig. 1) parallel zum Substrat integriert sind, wobei eine Schicht aus Aluminium ($n_1$, $n_2$, Fig. 1), bestehend aus zwei gegeneinander isolierten Bereichen, auf das Siliziumoxid aufgebracht ist, daß die Platten jedes integrierten, den Verstärker bildenden Kondensators aus einem an eine der Schichten aus polykristallinem Silizium angeschlossenen Bereich der Aluminiumschicht bestehen und daß eine Spannungsfolgerstufe ($T_1$, $T_2$, Fig. 1) mit ihrem Eingang an die Klemme ($B_1$, Fig. 1) jedes integrierten, den Verstärker bildenden Kondensators, die mit der die untere Schicht ($N_1$, Fig. 1) aus polykristallinem Silizium enthaltenden Kondensatorplatte verbunden ist, und mit ihrem Ausgang an eine in Bezug auf das Substrat (1, Fig. 1) den entgegengesetzten Leitfähigkeitstyp aufweisende Diffusionszone (3, Fig. 1) angeschlossen ist, die sich an der Grenzschicht Siliziumoxid-Silizium gegenüber den polykristallinen Siliziumschichten befinden, wobei nur die den Verstärker bildenden integrierten Kondensatoren, deren Klemme ($B_1$, Fig. 1) an Masse liegt, keine Folgerstufe und keine Diffusionszone aufweisen.

3. Filter nach einem der Ansprüche 1 oder 2, dadurch gekennzeichnet, daß die Spannungsfolgerstufe aus zwei MOS-Transistoren ($T_1$, $T_2$) besteht, die in Reihe zwischen einer Vorspannung ($V_{DD}$) und Masse liegen, wobei die Klemme $B_1$ des integrierten Kondensators an das Gitter des Transistors ($T_1$) angeschlossen ist, der mit der Vorspannung verbunden ist, während die Diffusionszone (3) und die den beiden Transistoren gemeinsame Elektrode an das Gitter des Transistors ($T_2$) angeschlossen sind, der an Masse liegt.

4. Filter nach einem der Ansprüche 1 oder 3, dadurch gekennzeichnet, daß die Spannungsfolgerstufe auf demselben Halbleitersubstrat (1) wie der Rest des Filters integriert ist.

5. Filter nach einem der Ansprüche 1 bis 4, dadurch gekennzeichnet, daß die Ausgangsstufe des Multiplizierers aus einer ersten Spannungsfolgerstufe, die in Reihe mit einem an seinem Gitter das Signal $\phi2$ empfangenden MOS-Transistors $T_3$ am Punkt A angeschlossen ist, und aus einer auf den Transistor ($T_3$) folgenden zweiten Spannungsfolgerstufe besteht, während ein Haltekondensator ($C_{20}$) zwischen den Punkt B und einen der zweiten Folgerstufe und dem Transistor $T_3$ gemeinsamen Punkt F, angebracht ist, wobei die Klemme $B_1$ dieses Kondensators am Punkt F liegt.

6. Filter nach einem der Ansprüche 2 bis 5, dadurch gekennzeichnet, daß der Multiplizierer mit umgeschalteten Kondensatoren zu schaltende Kondensatoren aufweist, die mit dem letzten Kondensator der Filterzelle zusammenfallen, wobei diese Filterzelle außerdem zwei in Reihe liegende Widerstände aufweist, die einerseits aus zwei MOS-Transistoren ($T_8$, $T_9$) in Reihe und einem Kondensator ($C_1$) zwischen deren gemeinsamen Punkt und Masse und andererseits aus einem MOS-Transistor ($T_{10}$), der in Reihe mit den Transistoren $T_{11}$ und $T_{12}$ des Verstärkers liegt, und einm Kondensator ($C_3$) zwischen deren Verbindungspunkt und Masse bestehen, wobei die Klemmen $B_1$ der beiden integrierten die Widerstände bildenden Kondensatoren ($C_1$, $C_3$) an Masse liegen, die Filterzelle auch einen Rückkopplungskondensator ($C_2$) zwischen dem Ausgang des Multiplizierers und dem Verbindungspunkt der Widerstände aufweist und die Klemme $B_1$ dieses Kondensators an den Ausgang des Verstärkers angeschlossen ist.

## Claims

1. A charge transfer filter comprising a differential amplifier which delivers the difference of voltages obtained from charges which are withdrawn from the cut electrodes of the filter, characterized in that said amplifier is constituted by a voltage multiplier comprising n condensors ($C_{11}$ to $C_{1n}$, fig. 2) which are periodically switched into a parallel and into a series configuration by MOS-type transistors ($T_{11}$ to $T_{2(n-1)}$, fig. 2), working as switch transistors, one voltage charging simultaneously the n condensors in parallel configuration and one amplified voltage being obtained between the outermost terminals (A and B, fig. 2) of the n condensors in a series configuration, and that the n condensors and the MOS transistors are integrated on a common semi-conductor substrate, and that the n condensors are realized on a silicon semi-conductor substrate (1, fig. 1) covered by a silica layer (2, fig. 1) in which two layers ($N_1$, $N_2$, fig. 1) of polycristalline silicon are integrated in parallel disposition to the substrate, an aluminium layer comprising two mutually isolated parts ($n_1$, $n_2$, fig. 1) being deposited on the silica, the plates of each integrated condensor being constituted by a part of the aluminium layer connected to one of the layers of polycristalline silicon, and that a voltage follower stage ($T_1$, $T_2$, fig. 1) is connected between the terminal ($B_1$, fig. 1) of each integrated condensor, which terminal is connected to the condensor plate comprising the lower layer ($N_1$, fig. 1) of polycristalline silicon and a diffused zone (3, fig. 1) of a type opposite to that of the substrate (1, fig. 1) which is disposed at the silica-silicon interface facing the polycristalline silicon layer, only the integrated condensors whose terminal ($B_1$, fig. 1) is connected to ground, not comprising a follower stage and a diffused zone.

2. A switched condensor filter comprising a filter cell which is constituted by condensors and MOS transistors associated to an amplifier, characterized in that said amplifier is constituted by a voltage multiplier comprising n condensors ($C_{11}$ to $C_{1n}$, fig. 2) which are periodically switched into a parallel and series configuration by MOS-type transistors ($T_{11}$ to $T_{2(n-1)}$, fig. 2) which work as switches, a common voltage charging simultaneously the n condensors in parallel configuration and an amplified voltage being obtained between the outermost terminals (A and B, fig. 2) of the n condensors in series configuration, and that the n condensors and the MOS transistors constituting the amplifier are integrated on a common semi-conductor substrate and that the n condensors which constitute the amplifier are realized on a silicon semi-conductor substrate (1, fig. 1) covered by a silica layer (2, fig. 1) in which two layers ($N_1$, $N_2$, fig. 1) of polycristalline silicon are integrated in parallel disposition to the substrate, an aluminium layer comprising two mutually isolated parts being deposited on the silica, the plates of each integrated amplifier condensor being constituted by a part of the aluminium layer connected to one of the layers of polycristalline silicon, and that a voltage follower stage ($T_1$, $T_2$, fig. 1) is connected by its input to the terminal ($B_1$, fig. 1) of each integrated amplifier condensor which is connected to the plate of the condensor comprising the lower layer ($N_1$, fig. 1) of polycristalline silicon, and by its output to a diffused zone (3, fig. 1) of a type opposite to that of the substrate (1, fig. 1) which is disposed at the silica-silicon interface facing the polycristalline silicon layer, only the integrated amplifier condensors whose terminal ($B_1$, fig. 1) is connected to ground not comprising a follower stage and a diffused zone.

3. A filter according to one of the claims 1 or 2, characterized in that the voltage follower stage is formed by two MOS-transistors ($T_1$, $T_2$) in series between a bias voltage ($V_{DD}$) and ground, the terminal $B_1$ of the integrated condensor being connected to the grid of the transistor ($T_1$) connected to the bias voltage, whereas the diffused zone (3) and the common electrode of the two transistors are connected to the grid of the transistor ($T_2$) connected to ground.

4. A filter according to one of the claims 1 or 3, characterized in that the voltage follower stage is integrated on the same semi-conductor substrate (1) as the rest of the filter.

5. A filter according to one of the claims 1 to 4, characterized in that the output stage of the multiplier is constituted by a first voltage follower stage connected to point A in series with a MOS transistor $T_3$ receiving on its grid the signal $\phi 2$, this transistor being followed by a second voltage follower stage while a holding condensor ($C_{20}$) is connected between point B and a point F common to the second follower stage and to the transistor $T_3$, the terminal $B_1$ of this condensor being connected to the point F.

6. A filter according to one of the claims 2 to 5, characterized in that the condensor switching multiplier comprises condensors to be switched merging with the last condensor of the filter cell, this filter cell further comprising two resistors in series configuration formed on the one hand from two MOS-transistors ($T_8$, $T_9$) in series and from a condensor ($C_1$) between their common point and ground, and on the other hand from a MOS-transistor ($T_{10}$) in series with transistors $T_{11}$ and $T_{12}$ of the amplifier and a condensor ($C_3$) between their common point and ground, the terminals ($B_1$) of the two integrated condensors ($C_1$, $C_3$) which constitute the resistors being connected to ground, the filter cell also comprising a looping condensor ($C_2$) between the output of the multiplier and the common point of the resistors, the terminal $B_1$ of this integrated condensor being connected to the output of the amplifier.

Fig. 1

Fig. 2

0 028 961

1

FIG. 3

FIG. 4